# EUROPEAN PATENT APPLICATION

(11) **EP 4 465 790 A1**
(43) Date of publication of application: **20.11.2024**
(21) Application number: 22920772.5
(22) Date of filing: 14.11.2022
(51) Int. Cl.: H10K 30/00, H10K 71/00

(54) **PEROVSKITE SOLAR CELL AND METHOD FOR PRODUCING SAME**

(30) Priority: 14.01.2022 KR 20220005573
(71) Applicant: Hanwha Solutions Corporation, Jung-gu Seoul 04541 (KR)
(72) Inventor: BACK, Hyung Cheol, Seongnam-si, Gyeonggi-do 13488 (KR); KIM, Geun Jin, Seongnam-si, Gyeonggi-do 13488 (KR); JEONG, Jun Kyeong, Seongnam-si, Gyeonggi-do 13488 (KR)
(74) Representative: Mooser, Sebastian Thomas
(86) International application number: PCT/KR2022/017885
(87) International publication number: WO 2023/136442

(57) **Abstract**

The present invention relates to a perovskite solar cell and a method for producing same, the perovskite solar cell having a transparent conductive oxide layer containing semi-conductive metal oxide added between an electron transport layer and a source electrode.

## Description

### [Technical Field]

The present invention relates to a perovskite solar cell and a method for producing the same, the perovskite solar cell having a transparent conductive oxide layer including a semiconducting metal oxide added between an electron transport layer and a source electrode.

### [Background Art]

To solve global environmental problems caused by the depletion of fossil energy and its use, research is actively being conducted on renewable and clean alternative energy sources such as solar energy, wind power, and hydropower.

Among these, interest in solar cells, which directly convert sunlight to electrical energy, is greatly increasing. Here, a solar cell refers to a cell that generates current-voltage using the photovoltaic effect in which electrons and holes are generated by absorbing light energy from sunlight.

Currently, n-p diode-type silicon (Si) single crystal-based solar cells with a light energy conversion efficiency of over 20% can be manufactured and are used in actual solar power generation, and there are solar cells using a compound semiconductor such as gallium arsenide (GaAs) with even better conversion efficiency. However, since these inorganic semiconductor-based solar cells require materials purified to a very high purity to achieve high efficiency, a lot of energy is consumed in purifying raw materials, and expensive processing equipment is required in the process of forming single crystals or thin films using raw materials. Therefore, there are limitations in lowering the manufacturing costs of solar cells, and these limitations have been an obstacle to their large-scale use.

Accordingly, to manufacture solar cells at low costs, it is necessary to significantly reduce the costs of the materials used as the core of solar cells or the costs of their manufacturing process, and research is being conducted on perovskite solar cells, which can be manufactured with low-cost materials and processes, as an alternative to inorganic semiconductor-based solar cells.

Recently, a perovskite solar cell using (NH₃CH₃)PbX₃ (X=I, Br, Cl), which is a halogen compound with a perovskite structure, as a photoactive material has been developed, and research for its commercialization is underway. The general structural formula of a perovskite structure is the ABX₃ structure, where an anion is located at the X site, a large-sized cation is positioned at the A site, and a small-sized cation is located at the B site.

Perovskite solar cells, which are organometallic halide compounds with the molecular formula (CH₃NH₃)PbX₃, were first used as a photoactive material in solar cells in 2009. Since the development of a solid-type perovskite solar cell with the current structure in 2012, rapid improvements in efficiency have been achieved. A typical perovskite solar cell uses a metal oxide as an electron transport layer (ETL) and mainly uses organic or polymeric materials such as spiro-OMETAD as a hole transport layer (HTL). In other words, a metal oxide porous film or thin film is formed on a transparent electrode such as fluorine-doped tin oxide (FTO), a perovskite material is applied, an HTL is applied, and then an electrode layer such as a gold (Au) or silver (Ag) layer is deposited.

In perovskite solar cells which are organometallic halide compounds with the molecular formula (CH₃NH₃)PbX₃, halide ions such as I, Br, and Cl is used at the X site of the molecular formula, and at this time, excess halides that fail to participate in the generation of a perovskite crystal phase are present in the form of ionic defects and are not fixed to the perovskite crystal but may escape from the crystal as a halide combined with hydrogen or a light cation, thus having high diffusivity. Therefore, after fabricating a Si/perovskite tandem device, halide ions easily diffuse into surrounding layers without constraints by heating, light irradiation, or external electrical factors that are essentially included in the subsequent module processes.

In particular, when the halide ions diffuse into an electrode layer of gold (Au) or silver (Ag) in a Si/perovskite tandem solar cell, they not only corrode a transparent electrode and a metal interface to increase interfacial contact resistance, but also corrode the metal electrode to cause the metal ions to leak into the interior of the solar cell devices, resulting in the problem of reducing the performance of the solar cell device.

### [Disclosure]

### [Technical Problem]

The present invention was devised to overcome the above-described problems, and an object of the present invention is provide a perovskite solar cell and a method of manufacturing the same, which are capable of minimizing a decrease in the performance of the perovskite solar cell and ensuring stability by introducing a transparent conductive oxide layer including a semiconducting metal oxide between an ETL and a source electrode so that the light transmission properties for a wavelength ranging from 350 to 1200 nm are not significantly changed and the sheet resistance is also not significantly changed.

### [Technical Solution]

To solve the above-described technical problems, a perovskite solar cell of the present invention includes a laminate in which a hole transport layer (HTL), a perovskite light absorption layer, an ETL, and a source electrode are sequentially laminated.

In one preferred embodiment of the present invention, a transparent conductive oxide layer may be formed between the source electrode and ETL.

In one preferred embodiment of the present invention, the transparent conductive oxide layer may include a semiconducting metal oxide.

In one preferred embodiment of the present invention, the transparent conductive oxide layer may have a structure in which a first transparent conductive oxide layer, a semiconducting metal oxide layer, and a second transparent conductive oxide layer are sequentially laminated.

In one preferred embodiment of the present invention, the first transparent conductive oxide layer may be a transparent thin film of deposited indium tin oxide (ITO), fluorine doped tin oxide (FTO), Sb₂O₃ doped tin oxide (ATO), gallium doped tin oxide (GTO), tin doped zinc oxide (ZTO), gallium doped ZTO (ZTO:Ga), indium gallium zinc oxide (IGZO), indium doped zinc oxide (IZO) or aluminum doped zinc oxide (AZO).

In one preferred embodiment of the present invention, the second transparent conductive oxide layer may be a transparent thin film of deposited ITO, FTO, ATO, GTO, ZTO, ZTO:Ga, IGZO, IZO or AZO.

In one preferred embodiment of the present invention, the semiconducting metal oxide layer may be a transparent thin film of deposited titanium oxide (TiOₓ), tin oxide (SnOₓ), niobium oxide (NbOₓ), zinc oxide (ZnO), zirconium oxide (ZrOₓ), magnesium oxide (MgOₓ), vanadium oxide (VOₓ), chromium oxide (CrOₓ) or molybdenum oxide (MoOₓ).

In one preferred embodiment of the present invention, the first transparent conductive oxide layer and the semiconducting metal oxide layer may have a thickness ratio of 1 :0.05 to 0.25.

In one preferred embodiment of the present invention, the second transparent conductive oxide layer and the semiconducting metal oxide layer may have a thickness ratio of 1 :0.05 to 0.25.

In one preferred embodiment of the present invention, the first transparent conductive oxide layer may have an average thickness of 5 to 100 nm.

In one preferred embodiment of the present invention, the semiconducting metal oxide layer may have an average thickness of 3 to 50 nm.

In one preferred embodiment of the present invention, the second transparent conductive oxide layer may have an average thickness of 5 to 100 nm.

In one preferred embodiment of the present invention, the perovskite solar cell may be a p-i-n-type perovskite solar cell, an n-i-p-type inverted perovskite solar cell, a tandem perovskite solar cell, or a tandem silicon/perovskite heterojunction solar cell.

In one preferred embodiment of the present invention, the transparent conductive oxide layer may have a light transmittance of 70% to 99% for a wavelength ranging from 350 to 1200 nm and a sheet resistance of 5 to 500 S2/sq.

Meanwhile, a method of manufacturing a perovskite solar cell according to the present invention includes Step 1 of forming a transparent conductive oxide layer through a deposition process on the top of an ETL of a laminate in which an HTL, a perovskite light absorption layer, and an ETL are sequentially laminated; and Step 2 of forming a source electrode on the top of the transparent conductive oxide layer, and the transparent conductive oxide layer includes a semiconducting metal oxide.

In one preferred embodiment of the present invention, the Step 1 may include: Step 1-1 of forming a first transparent conductive oxide layer through a deposition process on an ETL of a laminate in which an HTL, a perovskite light absorption layer, and an ETL are sequentially laminated; Step 1-2 of forming a semiconducting metal oxide layer on the first transparent conductive oxide layer through a deposition process; and Step 1-3 of forming a first transparent conductive oxide layer through a deposition process on the top of the semiconducting metal oxide layer.

Meanwhile, a tandem silicon/perovskite heterojunction solar cell according to the present invention includes a laminate in which a drain electrode, a silicon solar cell, a recombination layer, an HTL, a perovskite light absorption layer, an ETL, and a source electrode are sequentially laminated, and a transparent conductive oxide layer is formed between the source electrode and the ETL, and the transparent conductive oxide layer includes a semiconducting metal oxide.

### [Advantageous Effects]

The perovskite solar cell of the present invention includes a transparent conductive oxide layer including a semiconducting metal oxide between an ETL and a source electrode, so that the diffusion of halide anions from a perovskite light absorption layer to a source electrode interface of a metallic material and the resulting corrosion are prevented to increase lifespan. In addition, since optical properties can be changed and thus anti-reflection properties can be adjusted, performance can be improved.

### [Description of Drawings]

FIG. 1 shows a cross-sectional diagram illustrating a transparent conductive oxide layer according to a preferred embodiment of the present invention.
FIG. 2 shows a graph obtained by measuring the light transmittance of each transparent conductive oxide film prepared in Preparation Example 1, Preparation Example 2, and Comparative Preparation Example 1.

### [Modes of the Invention]

Hereinafter, the present invention will be described in more detail.

In existing perovskite solar cells, halide anions diffusing from a perovskite light absorption layer not only corrode a source electrode interface made of a metallic material to increase interfacial contact resistance, but also cause metal ions to leak into the interior of the perovskite solar cells due to the corrosion of the source electrode made of the metallic material, resulting in the problem of reducing the performance of the solar cells.

Therefore, the present invention relates to a perovskite solar cell including a transparent conductive oxide layer including a semiconducting metal oxide between an electron transport layer (ETL) and a source electrode, so that diffusion of halide anions from a perovskite light absorption layer to a source electrode interface made of a metallic material and the resulting corrosion are prevented to increase lifespan, and since optical properties can be changed, anti-reflection properties can be adjusted to improve performance.

The perovskite solar cell of the present invention may be a p-i-n-type perovskite solar cell, an n-i-p-type inverted perovskite solar cell, a tandem perovskite solar cell, or a tandem silicon/perovskite heterojunction solar cell, and preferably, a tandem silicon/perovskite heterojunction solar cell, and is a solar cell including a laminate having a structure in which a hole transport layer (HTL), a perovskite light absorption layer, an ETL, a transparent conductive oxide layer, and a source electrode are sequentially laminated.

In one preferred embodiment, when the perovskite solar cell of present invention is a tandem silicon/perovskite heterojunction solar cell, it may include a structure in which a drain electrode, a silicon solar cell, a recombination layer, and the laminate are sequentially laminated. Specifically, when the perovskite solar cell of present invention is a tandem silicon/perovskite heterojunction solar cell, it may include a structure in which a drain electrode, a silicon solar cell, a recombination layer, an HTL, a perovskite light absorption layer, an ETL, a transparent conductive oxide layer, and a source electrode are sequentially laminated.

The HTL may include inorganic and/or organic hole transport materials.

At this time, the inorganic hole transport material may include one or more selected from nickel oxide (NiOₓ), CuSCN, CuCrO₂, CuI, MoO, and V₂O₅.

In addition, the organic hole transport material may include one or more selected from carbazole derivatives, polyarylalkane derivatives, phenylenediamine derivatives, arylamine derivatives, amino-substituted chalcone derivatives, styrylanthracene derivatives, fluorene derivatives, hydrazone derivatives, stilbene derivatives, silazane derivatives, aromatic tertiary amine compounds, styrylamine compounds, aromatic dimethylidine-based compounds, porphyrin-based compounds, phthalocyanine-based compounds, polythiophene derivatives, polypyrrole derivatives, poly(p-phenylene vinylene) derivatives, pentacene, coumarin 6 (3-(2-benzothiazolyl)-7-(diethylamino)coumarin), zinc phthalocyanine (ZnPC), copper phthalocyanine (CuPC), titanium oxide phthalocyanine (TiOPC), 2,2',7,7'-tetrakis(N,N-p-dimethoxyphenylamino)-9,9'-spirobifluorene (Spiro-MeOTAD), copper(II) 1,2,3,4,8,9,10,11,15,16,17,18,22,23,24,25-hexadecafluoro-29H,31H-phthalocyanine (F16CuPC), boron subphthalocyanine chloride (SubPc) and cis-di(thiocyanato)-bis(2,2'-bipyridyl-4,4'-dicarboxylic acid)-ruthenium (II) (N3), poly[3-hexylthiophene] (P3HT), poly[2-methoxy-5-(3',7'-dimethyloctyloxyl)]-1,4-phenylene vinylene (MDMO-PPV), poly[2-methoxy-5-(2"-ethylhexyloxy)-p-phenylene vinylene] (MEH-PPV), poly(3-octyl thiophene) (P3OT), poly(octyl thiophene) (POT), poly(3-decyl thiophene) (P3DT), poly(3-dodecyl thiophene) (P3DDT), poly(p-phenylene vinylene) (PPV), poly(9,9'-dioctylfluorene-co-N-(4-butylphenyl)diphenyl amine) (TFB), polyaniline, 2,2',7,7'-tetrakis(N,N-p-dimethoxyphenylamino)-9,9'-spirobifluorene (Spiro-MeOTAD), poly[2,1,3-benzothiadiazole-4,7-diyl[4,4-bis(2-ethylhexyl-4H-cyclopenta[2,1-b:3,4-b']dithiophene-2,6-diyl]] (PCPDTBT), poly[(4,4'-bis(2-ethylhexyl)dithieno[3,2-b:2',3'-d]silole)-2,6-diyl-alt-(2,1,3-benzothiadiazole)-4,7-diyl] (Si-PCPDTBT), poly(4,8-diethylhexyloxyl) (PBDTTPD), poly[2,7-(9-(2-ethylhexyl)-9-hexyl-fluorene)-alt-5,5-(4',7,-di-2-thienyl-2',1',3'-benzothiadiazole)] (PFDTBT), poly[2,7-.9,9-(dioctyl-fluorene)-alt-5,5-(4',7'-di-2-.thienyl-2',1',3'-benzothiadiazole)] (PFO-DBT), poly[(2,7-dioctylsilafluorene)-2,7-diyl-alt-(4,7-bis(2-thienyl)-2,1,3-benzothiadiazole)-5,5'-diyl] (PSiFDTBT), poly[[9-(1-octylnonyl)-9H-carbazole-2,7-diyl]-2,5-thiophenediyl-2,1,3-benzothiadiazole-4,7-diyl-2,5-thiophenediyl] (PCDTBT), poly(9,9'-dioctylfluorene)-co-bis(N,N'-(4,butylphenyl))bis(N,N'-phenyl-1,4-phenylene)diamine) (PFB), poly(9,9'-dioctylfluorene-cobenzothiadiazole (F8BT), poly(3,4-ethylenedioxythiophene) (PEDOT), poly(3,4-ethylenedioxythiophene) poly(styrenesulfonate) (PEDOT:PSS), poly(triarylamine) (PTAA), (2-(9H-carbazol-9-yl)ethyl)phosphonic acid (2-PACz), 2-(3,6-dimethoxy-9H-carbazol-9-yl)ethyl)phosphonic acid (MeO-2PACz), (2-(3,6-dibromo-9H-carbazol-9-yl)ethyl)phosphonic acid (Br-2PACz), [4-(3,6-dimethyl-9H-carbazol-9-yl)butyl]phosphonic acid (Me-4PACz), (4-(3,6-dimethoxy-9H-carbazol-9-yl)butyl)phosphonic acid (MeO-4PACz), and (6-(9H-carbazol-9-yl)hexyl)phosphonic acid (6-PACz).

In addition, examples of the method of forming an HTL include a coating method and a vacuum deposition method, and examples of the coating method include a gravure coating method, a bar coating method, a printing method, a spraying method, a spin coating method, a dipping method, and a die coating method.

The perovskite light absorption layer may include a general perovskite material applied to a light absorption layer of a solar cell. For example, the perovskite light absorption layer may include a perovskite material represented by Chemical Formula 1 below.

[Chemical Formula 1] CMX₃

In Chemical Formula 1, C is a monovalent cation and may include amines, ammonium, Group 1 metals, Group 2 metals, and/or other cations or cation-like compounds, and may preferably be formamidinium (FA), methylammonium (MA), FAMA, CsFAMA or N(R)₄⁺ (Here, R may be the same or different group, and R is a straight-chain alkyl group with 1 to 5 carbon atoms, a branched alkyl group with 3 to 5 carbon atoms, a phenyl group, an alkylphenyl group, an alkoxyphenyl group, or an alkyl halide.).

In addition, M in Chemical Formula 1 is a divalent cation and may include one or two selected from Fe, Co, Ni, Cu, Sn, Pb, Bi, Ge, Ti, Eu, and Zr.

In addition, X in Chemical Formula 1 is a monovalent anion and may include one or more halide elements selected from F, Cl, Br, and I and/or a Group 16 anion, and as preferred example, X may be IₓBr₃₋ₓ (0≤x≤3).

In addition, a preferred example of Chemical Formula 1 may be FAPbIₓBr₃₋ₓ(0≤x≤3), MAPbIₓBr₃₋ₓ (0≤x≤3), CSMAFAPbIₓBr₃₋ₓ (0≤x≤3), CH₃NH₃PbX₃ (X= Cl, Br, I, BrI₂, or Br₂I), CH₃NH₃SnX₃ (X= Cl, Br, or I), CH(=NH)NH₃PbX₃ (X= Cl, Br, I, BrI₂, or Br₂I) or CH(=NH)NH₃SnX₃ (X= Cl, Br or I).

Meanwhile, in the perovskite solar cell of the present invention, the perovskite light absorption layer may be a single layer made of the same perovskite material, or may have a multilayer structure in which multiple layers made of different perovskite materials are laminated. In addition, in the light absorption layer made of one type of perovskite material, a different type of perovskite material from the type of perovskite material, which has shapes such as a pillar shape, a plate shape, a needle shape, a wire shape, or a rod shape, may be included.

In addition, examples of the method of forming a perovskite light absorption layer include a coating method and a vacuum deposition method, and examples of the coating method include gravure coating method, bar coating method, printing method, spraying method, spin coating method, dipping method, and die coating method.

The ETL may include one or more selected from fullerene (C₆₀), tin oxide (SnO₂), titanium dioxide (TiO₂), zinc oxide (ZnO), barium tin oxide (BaSnO₃), niobium hydroxide (NbOH), and niobium pentoxide (Nb₂O₅).

In addition, examples of the method of forming an ETL include a coating method and/or a vacuum deposition method, and examples of the coating method include a gravure coating method, a bar coating method, a printing method, a spraying method, a spin coating method, a dipping method, and a die coating method, and preferably, an ETL on the perovskite light absorption layer may be formed through a vacuum deposition and/or atomic layer deposition (ALD) process.

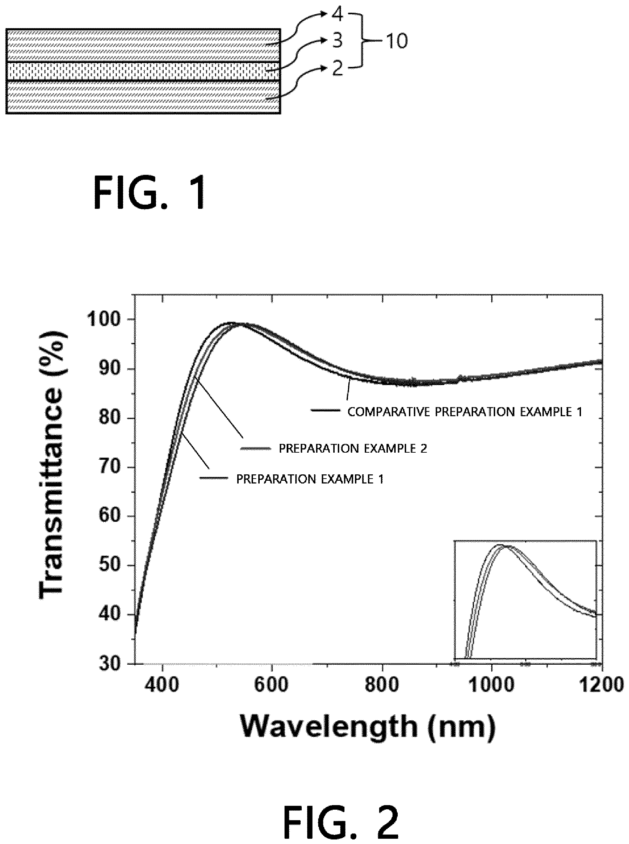

Referring to FIG. 1, a transparent conductive oxide layer 10 may be formed on an ETL through a deposition process or a solution process, preferably a deposition process.

At this time, the deposition may be performed using a general deposition process used in the art, and preferably, the deposition process may be performed through a sputtering process or an ALD process.

In addition, the transparent conductive oxide layer 10 may include a semiconducting metal oxide.

Specifically, the transparent conductive oxide layer 10 may have a structure in which a first transparent conductive oxide layer 2, a semiconducting metal oxide layer 3, and a second transparent conductive oxide layer 4 are sequentially laminated, and preferably, a semiconducting metal oxide may be included in the semiconducting metal oxide layer 3. In other words, by forming a first transparent conductive oxide layer 2 on an ETL through a deposition process, forming a semiconducting metal oxide layer 3 on the first transparent conductive oxide layer 2 through a deposition process, and forming a second transparent conductive oxide layer 4 on the semiconducting metal oxide layer 3 through a deposition process, the transparent conductive oxide layer 10 may have a structure in which a first transparent conductive oxide layer 2, a semiconducting metal oxide layer 3, and a second transparent conductive oxide layer 4 are sequentially laminated.

Meanwhile, the first transparent conductive oxide layer 2 may be a transparent thin film of deposited indium tin oxide (ITO), fluorine doped tin oxide (FTO), Sb₂O₃ doped tin oxide (ATO), gallium doped tin oxide (GTO), tin doped zinc oxide (ZTO), gallium doped ZTO (ZTO:Ga), indium gallium zinc oxide (IGZO), indium doped zinc oxide (IZO) or aluminum doped zinc oxide (AZO).

In addition, the second transparent conductive oxide layer 4 may be a transparent thin film of deposited ITO, FTO, ATO, GTO, ZTO, ZTO:Ga, IGZO, IZO or AZO.

In addition, the semiconducting metal oxide layer 3 may be a transparent thin film of deposited titanium oxide (TiOₓ), tin oxide (SnOₓ), niobium oxide (NbOₓ), zinc oxide (ZnO), zirconium oxide (ZrOₓ), magnesium oxide (MgOₓ), vanadium oxide (VOₓ), chromium oxide (CrOₓ) or molybdenum oxide (MoOₓ).

Specifically, the first transparent conductive oxide layer 2 and the semiconducting metal oxide layer 3 may have a thickness ratio of 1:0.05 to 0.25, preferably, a thickness ratio of 1:0.05 to 0.184, more preferably, a thickness ratio of 1:0.08 to 0.15, and further more preferably, a thickness ratio of 1:0.08 to 0.117. When the thickness ratio is less than 1:0.05, there may be a problem in protecting the electrodes, and when it exceeds 1:0.25, there may be a problem that the performance of a solar cell deteriorates due to increased internal resistance.

In addition, the second transparent conductive oxide layer 4 and the semiconducting metal oxide layer 3 may have a thickness ratio of 1:0.05 to 0.25, preferably, a thickness ratio of 1:0.05 to 0.184, more preferably, a thickness ratio of 1:0.08 to 0.15, and even more preferably, a thickness ratio of 1:0.08 to 0.117. When the thickness ratio is less than 1:0.05, there may be a problem in protecting the electrodes, and when it exceeds 1:0.25, there may be a problem that the performance of a solar cell deteriorates due to increased internal resistance.

Meanwhile, the first transparent conductive oxide layer 2 may have an average thickness of 5 to 100 nm, preferably 20 to 80 nm, and more preferably 30 to 70 nm. When the average thickness is less than 5 nm, there may be a problem that the performance of a solar cell deteriorates due to increased internal resistance, and when it exceeds 100 nm, there may be a problem that the light transmittance of long wavelengths is decreased.

In addition, the second transparent conductive oxide layer 4 may have an average thickness of 5 to 100 nm, preferably 20 to 80 nm, and more preferably 30 to 70 nm. When the average thickness is less than 5 nm, there may be a problem that the performance of a solar cell deteriorates due to increased internal resistance, and when it exceeds 100 nm, there may be a problem that the light transmittance of long wavelengths is decreased.

In addition, the semiconducting metal oxide layer 3 may have an average thickness of 3 to 50 nm, preferably 3 to 15 nm, more preferably 4 to 11 nm, further more preferably, 5 to 9 nm, and further more preferably 5 to 7 nm. When the average thickness is less than 3 nm, there may be a problem in protecting the electrodes, and when it exceeds 50 nm, there may be a problem that the performance of a solar cell deteriorates due to increased internal resistance.

The source electrode may be formed on the top of the transparent conductive oxide layer through a coating or deposition process. In addition, the source electrode may include one or more selected from Pt, Au, Ni, Cu, Ag, In, Ru, Pd, Rh, Ir, Os, C, and conductive polymers.

In addition, the solar cell of the present invention may further include a passivation layer between the light absorption layer and the ETL.

The drain electrode may be manufactured from a material including one or more selected from conductive metals, conductive metal alloys, metal oxides, and conductive polymers, and preferred examples may include ITO, FTO, ATO, GTO, ZTO, ZTO:Ga, IGZO, IZO and/or AZO.

Meanwhile, a method of manufacturing a perovskite solar cell according to the present invention includes: Step 1 of forming a transparent conductive oxide layer through a deposition process on an ETL of a laminate in which an HTL, a perovskite light absorption layer, and an ETL are sequentially laminated; and Step 2 of forming a source electrode on the transparent conductive oxide layer, and the transparent conductive oxide layer includes a semiconducting metal oxide.

Specifically, Step 1 of the method of manufacturing the perovskite solar cell according to the present invention may include: Step 1-1 of forming a first transparent conductive oxide layer through a deposition process on an ETL of a laminate in which an HTL, a perovskite light absorption layer, and an ETL are sequentially laminated; Step 1-2 of forming a semiconducting metal oxide layer on the first transparent conductive oxide layer through a deposition process; and Step 1-3 of forming a first transparent conductive oxide layer on the semiconducting metal oxide layer through a deposition process, and the specific description of each layer is the same as described above.

Hereinafter, the present invention will be described in more detail through examples. However, the following examples do not limit the scope of the present invention and should be interpreted to aid understanding of the present invention.

### Preparation Example 1: Manufacture of transparent conductive oxide film

A clean glass substrate was prepared, and IZO was deposited on the glass substrate through a sputtering process to form a first transparent conductive oxide layer with an average thickness of 60 nm.

Next, tin (II) oxide (SnO) was deposited on the top of the first transparent conductive oxide layer through an ALD process to form a semiconducting metal oxide layer with an average thickness of 6 nm.

Next, IZO was deposited on the semiconducting metal oxide layer through a sputtering process to form a second transparent conductive oxide layer with an average thickness of 60 nm, thereby manufacturing a transparent conductive oxide film.

### Preparation Example 2: Manufacture of transparent conductive oxide film

A cleaned glass substrate was prepared, and IZO was deposited on the glass substrate through a sputtering process to form a first transparent conductive oxide layer with an average thickness of 60 nm.

Next, tin (II) oxide (SnO) was deposited on the first transparent conductive oxide layer through an ALD process to form a semiconducting metal oxide layer with an average thickness of 3 nm.

Next, IZO was deposited on the semiconducting metal oxide layer through a sputtering process to form a second transparent conductive oxide layer with an average thickness of 60 nm, thereby manufacturing a transparent conductive oxide film.

### Comparative Preparation Example 1: Manufacture of transparent conductive oxide film

A cleaned glass substrate was prepared, and IZO was deposited on the glass substrate through a sputtering process to form a first transparent conductive oxide film with an average thickness of 120 nm.

### Experimental Example 1: Measurement of sheet resistance and light transmittance

To confirm the electrical and optical properties of the transparent conductive oxide films manufactured in Preparation Examples 1 and 2 and Comparative Preparation 1, the transparent conductive oxide films prepared in Preparation Examples 1 and 2 and Comparative Preparation 1 were each laminated on one surface of bare glass, the light transmittance (FIG. 2) in the wavelength range of 350 nm to 1200 nm was measured using UV-Vis spectroscopy, and the sheet resistance of the transparent conductive oxide films was measured using the 4-point probe method, and the measurement results are shown in Table 1 below.

**[Table 1]**

| Classification | Sheet resistance (Ω/sq) | Light transmittance (%) |
|---|---|---|
| Preparation Example 1 | 36.75 | 89.20 |
| Preparation Example 2 | 37.02 | 89.78 |
| Comparative Preparation Example 1 | 41.83 | 89.54 |

As can be seen in Table 1, it can be confirmed that the transparent conductive oxide films prepared in Preparation Examples 1 and 2 and the transparent conductive oxide film prepared in Comparative Preparation Example 1 showed similar levels of sheet resistance and light transmittance, and through this, it was confirmed that even when the transparent conductive oxide films prepared in Preparation Examples 1 and 2 are used in a solar cell generally using the transparent conductive oxide film prepared in Comparative Preparation Example 1, the performance of the solar cell is not deteriorated because the electrical and optical properties are similar.

### Example 1: Manufacture of tandem silicon/perovskite heterojunction solar cell

As a lower solar cell, an n- or p-type silicon solar cell doped with impurities was treated with hydrofluoric acid to remove a SiOₓ oxide film, and then the remaining hydrofluoric acid was removed using ultrapure water. A thin recombination layer was formed through a sputtering process on the silicon solar cell from which the oxide film was removed.

Next, an HTL (NiOₓ) with a thickness of 30 nm was formed on the silicon solar cell under E-beam vacuum deposition method conditions.

Next, a yellow light absorption layer solution formed by dissolution in dimethylformamide (DMF) and dimethyl sulfoxide (DMSO) was applied on the HTL through spin coating and then heat-treated at 100 °C for 20 minutes to form a NiOₓ HTL and a light absorption layer (CSMAFAPbIₓBr₃₋ₓ (0≤x≤3)) having a perovskite crystal structure with a thickness of 450 to 900 nm.

Next, fullerene (C₆₀) was deposited on the top of the perovskite light absorption layer through vacuum deposition, and SnOₓ was deposited through an ALD process on the top of the perovskite light absorption layer on which fullerene (C₆₀) had been deposited to form an ETL with an average thickness of 20 nm.

Next, IZO was deposited on the ETL through a sputtering process to form a first transparent conductive oxide layer with an average thickness of 60 nm.

Next, tin (II) oxide (SnO) was deposited on the top of the first transparent conductive oxide layer through an ALD process to form a semiconducting metal oxide layer with an average thickness of 6 nm.

Next, IZO was deposited on the semiconducting metal oxide layer through a sputtering process to form a second transparent conductive oxide layer with an average thickness of 60 nm.

Next, silver (Ag) was deposited on the second transparent conductive oxide layer to a thickness of 100 nm at a pressure of 1×10⁻⁷ torr to form a source electrode, thereby manufacturing a tandem silicon/perovskite heterojunction solar cell in which a silicon solar cell, a recombination layer, an HTL, a perovskite light absorption layer, an ETL, a first transparent conductive oxide layer, a semiconducting metal oxide layer, a second transparent conductive oxide layer, and a source electrode are sequentially laminated.

### Example 2: Manufacture of tandem silicon/perovskite heterojunction solar cell

A tandem silicon/perovskite heterojunction solar cell was manufactured in the same manner as in Example 1. However, unlike Example 1, the semiconducting metal oxide layer was formed with an average thickness of 3 nm on the first transparent conductive oxide layer to ultimately manufacture a tandem silicon/perovskite heterojunction solar cell.

### Example 3: Manufacture of tandem silicon/perovskite heterojunction solar cell

A tandem silicon/perovskite heterojunction solar cell was manufactured in the same manner as in Example 1. However, unlike Example 1, the semiconducting metal oxide layer was formed with an average thickness of 8 nm on the first transparent conductive oxide layer to ultimately manufacture a tandem silicon/perovskite heterojunction solar cell.

### Example 4: Manufacture of tandem silicon/perovskite heterojunction solar cell

A tandem silicon/perovskite heterojunction solar cell was manufactured in the same manner as in Example 1. However, unlike Example 1, the semiconducting metal oxide layer was formed with an average thickness of 12 nm on the first transparent conductive oxide layer to ultimately manufacture a tandem silicon/perovskite heterojunction solar cell.

### Example 5: Manufacture of tandem silicon/perovskite heterojunction solar cell

A tandem silicon/perovskite heterojunction solar cell was manufactured in the same manner as in Example 1. However, unlike Example 1, the semiconducting metal oxide layer was formed by depositing titanium oxide (TiOₓ) with an average thickness of 10 nm on the top of the first transparent conductive oxide layer through a solution process to ultimately manufacture a tandem silicon/perovskite heterojunction solar cell.

### Comparative Example 1: Manufacture of tandem silicon/perovskite heterojunction solar cell

As a lower solar cell, an n- or p-type silicon solar cell doped with impurities was treated with hydrofluoric acid to remove a SiOₓ oxide film, and then the remaining hydrofluoric acid was removed using ultrapure water. A thin recombination layer was formed through a sputtering process on the silicon solar cell from which the oxide film was removed.

Next, an HTL (NiOₓ) with a thickness of 30 nm was formed on the silicon solar cell under E-beam vacuum deposition method conditions.

Next, a yellow light absorption layer solution formed by dissolution in DMF and DMSO was applied on the HTL through spin coating and then heat-treated at 100 °C for 20 minutes to form a NiOₓ HTL and a light absorption layer (CSMAFAPbIₓBr₃₋ₓ (0≤x≤3)) having a perovskite crystal structure with a thickness of 450 to 900 nm.

Next, fullerene (C₆₀) was deposited on the top of the perovskite light absorption layer through vacuum deposition, and SnOₓ was deposited through an ALD process on the perovskite light absorption layer on which fullerene (C₆₀) had been deposited to form an ETL with an average thickness of 20 nm.

Next, IZO was deposited on the ETL through a sputtering process to form a transparent conductive oxide layer with an average thickness of 120 nm.

Next, silver (Ag) was deposited on the transparent conductive oxide layer to a thickness of 100 nm at a pressure of 1×10⁻⁷ torr to form a source electrode, thereby manufacturing a tandem silicon/perovskite heterojunction solar cell in which a silicon solar cell, a recombination layer, an HTL, a perovskite light absorption layer, an ETL, a transparent conductive oxide layer, and a source electrode are sequentially laminated.

### Experimental Example 2: Measurement of performance and long-term storage stability of solar cell

The performance and long-term storage stability of each of the tandem silicon/perovskite heterojunction solar cells manufactured in Examples 1, 2, and 5 and the tandem silicon/perovskite heterojunction solar cell manufactured in Comparative Example 1 were measured, and the results are shown in Table 2 below.

Specifically, the efficiency of solar cells was measured using the initial current density-voltage (JV) curve using solar power simulation equipment and JV Keithley equipment, and then changes in the characteristics of the solar cells after aging were measured by measuring the JV curve after storing them in a desiccator for 14 days.

**[Table 2]**

| Classificatio n | Aging time (day) | Open-circuit voltage (V_{oc}, V) | Short-circuit current density (J_{sc}, mA/cm²) | Fill factor (FF) | Photoelectric conversion efficiency (%) | Series R (Ω) | Reduction rate (%) |
|---|---|---|---|---|---|---|---|
| Example 1 | 1 | 1.839 | 19.36 | 75.14 | 26.75 | 8.3 | 1.34 |
| | 14 | 1.848 | 19.63 | 74.76 | 27.11 | 8.31 | |
| Example 2 | 1 | 1.838 | 19.09 | 75.27 | 26.4 | 8.61 | -6.48 |
| | 14 | 1.834 | 19.29 | 69.76 | 24.69 | 10.89 | |
| Example 5 | 1 | 1.835 | 19.36 | 75.14 | 26.69 | 7.41 | -5.02 |
| | 14 | 1.831 | 19.63 | 70.54 | 25.35 | 11.43 | |
| Comparative Example 1 | 1 | 1.842 | 19.44 | 74.07 | 26.53 | 7.78 | -17.94 |
| | 14 | 1.813 | 19.56 | 61.37 | 21.77 | 22.54 | |

As can be seen in Table 2, it can be confirmed that the tandem silicon/perovskite heterojunction solar cells manufactured in Examples 1 and 2 had a higher series resistance (aging time 1 day) than that of the tandem silicon/perovskite heterojunction solar cell manufactured in Comparative Example 1, and it can be also confirmed that the efficiency reduction rate was significantly less.

In addition, it can be confirmed that the tandem silicon/perovskite heterojunction solar cell manufactured in Example 5 showed a significantly lower efficiency reduction rate than that of the tandem silicon/perovskite heterojunction solar cell manufactured in Comparative Example 1.

### Experimental Example 3: Measurement of performance and long-term storage stability of solar cell before and after thermal shock

The performance and long-term storage stability of each of the tandem silicon/perovskite heterojunction solar cells manufactured in Examples 1, 3, 4, and 5 and the tandem silicon/perovskite heterojunction solar cell manufactured in Comparative Example 1 were measured before and after thermal shock, and the results are shown in Table 3 below.

Specifically, the efficiency of solar cells was measured using the initial JV curve using solar power simulation equipment and JV Keithley equipment, and then changes in the characteristics of the solar cells after thermal shock were measured by measuring the JV curve after heating the solar cells at 130 °C for 10 minutes.

**[Table 3]**

| Classificatio n | Before or after thermal shock | Open-circuit voltage (V_{oc}, V) | Short-circuit current density (J_{sc}, mA/cm²) | Fill factor (FF) | Photoelectric conversion efficiency (%) | Series R (Ω) | Reduction rate (%) |
|---|---|---|---|---|---|---|---|
| Example 1 | Before thermal shock | 1.771 | 19.89 | 66.44 | 23.40 | 11.83 | -13 |
| | After thermal shock | 1.724 | 19.68 | 59.96 | 20.34 | 16.26 | |
| Example 3 | Before thermal shock | 1.763 | 19.45 | 69.52 | 23.84 | 11.58 | -13 |
| | After thermal shock | 1.727 | 19.65 | 60.88 | 20.67 | 15.51 | |
| Example 4 | Before thermal shock | 1.739 | 19.40 | 66.23 | 22.34 | 14.08 | -15 |
| | After thermal shock | 1.702 | 19.33 | 57.87 | 19.04 | 19.02 | |
| Example 5 | Before thermal shock | 1.763 | 19.27 | 72.86 | 24.75 | 9.63 | -19 |
| | After thermal shock | 1.728 | 19.46 | 59.69 | 20.08 | 19.88 | |
| Comparative Example 1 | Before thermal shock | 1.827 | 19.42 | 70.1 | 24.87 | 10.66 | -35 |
| | After thermal shock | 1.736 | 18.75 | 49.41 | 16.08 | 38.59 | |

As can be seen in Table 3, it can be confirmed that the tandem silicon/perovskite heterojunction solar cells manufactured in Examples 1, 3, 4, and 5 showed a significantly lower efficiency reduction rate before and after the thermal shock than that of the tandem silicon/perovskite heterojunction solar cell manufactured in Comparative Example 1.

In the above, specific embodiments are illustrated and described. However, the present invention is not limited to the above-described embodiments, and those skilled in the art to which the present invention pertains may make various changes without departing from the gist of the technical spirit of the invention as set forth in the claims below.

### [Industrial Applicability]

The present invention relates to a perovskite solar cell and a method of producing the same, the perovskite solar cell having a transparent conductive oxide layer including a semiconducting metal oxide added between an electron transport layer and a source electrode.

## Claims

1. A perovskite solar cell comprising a laminate in which a hole transport layer, a perovskite light absorption layer, an electron transport layer, and a source electrode are sequentially laminated,
wherein a transparent conductive oxide layer is formed between the source electrode and the electron transport layer, and
the transparent conductive oxide layer includes a semiconducting metal oxide.

2. The perovskite solar cell of claim 1, wherein the transparent conductive oxide layer has a structure in which a first transparent conductive oxide layer, a semiconducting metal oxide layer, and a second transparent conductive oxide layer are sequentially laminated.

3. The perovskite solar cell of claim 2, wherein the first transparent conductive oxide layer and the second transparent conductive oxide layer are each a transparent thin film of deposited indium tin oxide (ITO), fluorine doped tin oxide (FTO), Sb₂O₃ doped tin oxide (ATO), gallium doped tin oxide (GTO), tin doped zinc oxide (ZTO), gallium doped ZTO (ZTO:Ga), indium gallium zinc oxide (IGZO), indium doped zinc oxide (IZO) or aluminum doped zinc oxide (AZO), and
the semiconducting metal oxide layer is a transparent thin film oftitanium oxide (TiOₓ), tin oxide (SnOₓ), niobium oxide (NbOₓ), zinc oxide (ZnO), zirconium oxide (ZrOₓ), magnesium oxide (MgOₓ), vanadium oxide (VOₓ), chromium oxide (CrOₓ) or molybdenum oxide (MoOₓ).

4. The perovskite solar cell of claim 2, wherein the first transparent conductive oxide layer and the semiconducting metal oxide layer have a thickness ratio of 1 :0.05 to 0.25, and
the second transparent conductive oxide layer and the semiconducting metal oxide layer have a thickness ratio of 1 :0.05 to 0.25.

5. The perovskite solar cell of claim 2, wherein the first transparent conductive oxide layer and the second transparent conductive oxide layer each have an average thickness of 5 to 100 nm, and
the semiconducting metal oxide layer has an average thickness of 3 to 50 nm.

6. The perovskite solar cell of any one selected from claims 1 to 5, wherein the perovskite solar cell is a p-i-n-type perovskite solar cell, an n-i-p-type inverted perovskite solar cell, a tandem perovskite solar cell, or a tandem silicon/perovskite heterojunction solar cell.

7. The perovskite solar cell of claim 1, wherein the transparent conductive oxide layer has a light transmittance of 70% to 99% for a wavelength ranging from 350 to 1200 nm and a sheet resistance of 5 to 500 S2/sq.

8. A method of manufacturing a perovskite solar cell, comprising:
Step 1 of forming a transparent conductive oxide layer through a deposition process on an electron transport layer of a laminate in which a hole transport layer, a perovskite light absorption layer, and an electron transport layer are sequentially laminated; and
Step 2 of forming a source electrode on the transparent conductive oxide layer,
wherein the transparent conductive oxide layer includes a semiconducting metal oxide.

9. The method of claim 8, wherein Step 1 includes:
Step 1-1 of forming a first transparent conductive oxide layer through a deposition process on an electron transport layer of a laminate in which a hole transport layer, a perovskite light absorption layer, and an electron transport layer are sequentially laminated;
Step 1-2 of forming a semiconducting metal oxide layer on the first transparent conductive oxide layer through a deposition process; and
Step 1-3 of forming a first transparent conductive oxide layer on the semiconducting metal oxide layer through a deposition process.

10. A tandem silicon/perovskite heterojunction solar cell, comprising a laminate in which a drain electrode, a silicon solar cell, a recombination layer, a hole transport layer, a perovskite light absorption layer, an electron transport layer, and a source electrode are sequentially laminated,
wherein a transparent conductive oxide layer is formed between the source electrode and the electron transport layer, and
the transparent conductive oxide layer includes a semiconducting metal oxide.
